(19) Europäisches Patentamt
European Patent Office
Office européen des brevets

(11) **EP 2 157 584 A2**

(12) **EUROPEAN PATENT APPLICATION**

(43) Date of publication:
**24.02.2010 Bulletin 2010/08**

(51) Int Cl.:
***G21K 1/06*** *(2006.01)*

(21) Application number: **09166629.7**

(22) Date of filing: **28.07.2009**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**
Designated Extension States:
**AL BA RS**

(30) Priority: **14.08.2008 US 136147 P**
**13.10.2008 US 104851 P**

(71) Applicant: **ASML Netherlands B.V.**
**5504 DR Veldhoven (NL)**

(72) Inventors:
• **Van Herpen, Maarten**
  **5384 HS, Heesch (NL)**
• **Banine, Vadim**
  **5704 NK, Helmond (NL)**
• **Klunder, Derk**
  **5666 RS, Geldrop (NL)**
• **Soer, Wouter**
  **6546 VV, Nijmegen (NL)**

(74) Representative: **Slenders, Petrus J. W.**
**ASML Netherlands B.V.**
**De Run 6504**
**5504 DR Veldhoven (NL)**

(54) **Radiation source, lithographic apparatus and device manufacturing method**

(57)    A lithographic apparatus includes a radiation source configured to produce extreme ultraviolet radiation. The radiation source includes a chamber in which a plasma is generated, and a mirror configured to reflect radiation emitted by the plasma. The mirror includes a multi-layer structure that includes alternating Mo/Si layers. A boundary Mo layer or a boundary Si layer or a boundary diffusion barrier layer of the alternating layers forms a top layer of the mirror, the top layer facing inwardly with respect to the chamber. A hydrogen radical generator is configured to generate hydrogen radicals in the chamber. The hydrogen radicals are configured to remove debris generated by the plasma from the mirror.

**FIG. 3**

**Description**

FIELD

The present invention relates to a lithographic apparatus, a radiation source, and a method for producing extreme ultraviolet radiation.

BACKGROUND

A lithographic apparatus is a machine that applies a desired pattern onto a substrate, usually onto a target portion of the substrate. A lithographic apparatus can be used, for example, in the manufacture of integrated circuits (ICs). In that example, a patterning device, which is alternatively referred to as a mask or a reticle, may be used to generate a circuit pattern to be formed on an individual layer of the IC. This pattern can be transferred onto a target portion (e.g. including part of one or several dies) on a substrate (e.g. a silicon wafer). Transfer of the pattern is typically via imaging onto a layer of radiation-sensitive material (resist) provided on the substrate. In general, a single substrate will contain a network of adjacent target portions that are successively patterned. Known lithographic apparatus include steppers, in which each target portion is irradiated by exposing an entire pattern onto the target portion at one time, and scanners, in which each target portion is irradiated by scanning the pattern through a radiation beam in a given direction (the "scanning" direction) while synchronously scanning the substrate parallel or anti-parallel to this direction. It is also possible to transfer the pattern from the patterning device to the substrate by imprinting the pattern onto the substrate.

A theoretical estimate of the limits of pattern printing can be given by the Rayleigh criterion for resolution as shown in equation (1):

$$CD = k_1 * \frac{\lambda}{NA_{PS}} \qquad (1)$$

where $\lambda$ is the wavelength of the radiation used, $NA_{PS}$ is the numerical aperture of the projection system used to print the pattern, $k_1$ is a process dependent adjustment factor, also called the Rayleigh constant, and CD is the feature size (or critical dimension) of the printed feature. It follows from equation (1) that reduction of the minimum printable size of features can be obtained in three ways: by shortening the exposure wavelength $\lambda$, by increasing the numerical aperture $NA_{PS}$ or by decreasing the value of $k_1$.

In order to shorten the exposure wavelength and, thus, reduce the minimum printable size, it has been proposed to use an extreme ultraviolet (EUV) radiation source. EUV radiation sources are configured to output a radiation wavelength of about 13 nm. Thus, EUV radiation sources may constitute a significant step toward achieving small features printing. Such radiation is termed extreme ultraviolet or soft x-ray, and possible sources include, for example, laser-produced plasma sources, discharge plasma sources, or synchrotron radiation from electron storage rings.

The source of EUV radiation is typically a plasma source, for example a laser-produced plasma or a discharge source. When using a plasma source, contamination particles are created as a by-product of the EUV radiation. Generally, such particles are undesired because they may inflict damage on parts of the lithographic apparatus, most notably mirrors which are located in the vicinity of the plasma source.

SUMMARY

In an aspect of the invention, there is provided a lithographic apparatus including a radiation source configured to produce extreme ultraviolet radiation, the radiation source including a chamber in which a plasma is generated; a mirror configured to reflect radiation emitted by the plasma, the mirror including a multi-layer structure including alternating Mo/Si layers, wherein a boundary Mo layer, a boundary Si layer or a boundary diffusion barrier layer of the alternating layers forms a top layer of the mirror, the top layer facing inwardly with respect to the chamber; and a hydrogen radical generator configured to generate hydrogen radicals in the chamber, the hydrogen radicals configured to remove debris generated by the plasma from the mirror.

In another aspect of the invention, there is provided a radiation source configured to produce extreme ultraviolet radiation, the radiation source including a chamber in which a plasma is generated; a mirror configured to reflect radiation emitted by the plasma, the mirror including a multi-layer structure including alternating Mo/Si layers, wherein a boundary Mo layer, a boundary Si layer or a boundary diffusion barrier layer of the alternating layers forms a top layer of the mirror, the top layer facing inwardly with respect to the chamber; and a hydrogen radical generator configured to generate hydrogen radicals in the chamber, the hydrogen radicals configured to remove debris generated by the plasma from the mirror.

In yet another aspect of the invention, there is provided a device manufacturing method including generating a plasma that emits a beam of radiation; reflecting the beam of radiation with a mirror, the mirror including a multi-layer structure including alternating Mo/Si layers, wherein a boundary Mo layer, a boundary Si layer or a boundary diffusion barrier layer of the alternating layers forms a top layer of the mirror, the top layer facing inwardly with respect to the chamber; directing the beam of radiation onto a target portion of a substrate; and removing debris produced by the plasma from a surface of the mirror with hydrogen radicals.

In still another aspect of the invention, there is provided a mirror cleaning method, comprising removing debris using hydrogen radicals from a mirror that is arranged for reflecting a beam of extreme ultraviolet radiation emitted by a plasma in a chamber, the mirror including a multi-layer structure including alternating Mo/Si layers, wherein a boundary Mo layer, a boundary Si layer or a boundary diffusion barrier layer of the alternating layers forms a top layer of the mirror, the top layer facing inwardly with respect to the chamber.

BRIEF DESCRIPTION OF THE DRAWINGS

Embodiments of the present invention will now be described, by way of example only, with reference to the accompanying schematic drawings in which corresponding reference symbols indicate corresponding parts, and in which:

Figure 1 schematically depicts a lithographic apparatus according to an embodiment of the invention;

Figure 2 schematically depicts a side view of an EUV illumination system and projection optics of a lithographic projection apparatus according to Figure 1;

Figure 3 depicts a radiation source and a normal incidence collector in accordance with an embodiment of the invention;

Figure 4 depicts a radiation source and a Schwarzschild type normal incidence collector in accordance with an embodiment of the invention;

Figure 5 depicts a multi-layer Mo/Si mirror with a cap layer in accordance with an embodiment of the invention;

Figure 6 shows an experimental setup in accordance with an embodiment of the invention;

Figure 7 shows a side view of a vacuum chamber in accordance with an embodiment of the invention;

Figure 8 shows a front view of the vacuum chamber of Figure 7 in accordance with an embodiment of the invention;

Figure 9 shows variations of the cleaning rates for various cap layers in accordance with an embodiment of the invention;

Figure 10 shows reflectivity curves for a 1 nm $B_4C$ sample before and after cleaning in accordance with an embodiment of the invention;

Figure 11 shows reflectivity curves for a 1.5 nm $B_4C$ sample before and after cleaning in accordance with an embodiment of the invention;

Figure 12 shows reflectivity curves for a 2.5 nm $B_4C$ sample before and after cleaning in accordance with an embodiment of the invention;

Figure 13 shows reflectivity curves for a 7 nm $B_4C$ sample before and after cleaning in accordance with an embodiment of the invention;

Figure 14 shows a comparison of cleaning rates for Mo and Mo-oxide in accordance with an embodiment of the invention; and

Figure 15 shows a comparison of cleaning rates (logarithmic plot) for Mo and Mo-oxide in accordance with an embodiment of the invention.

DETAILED DESCRIPTION

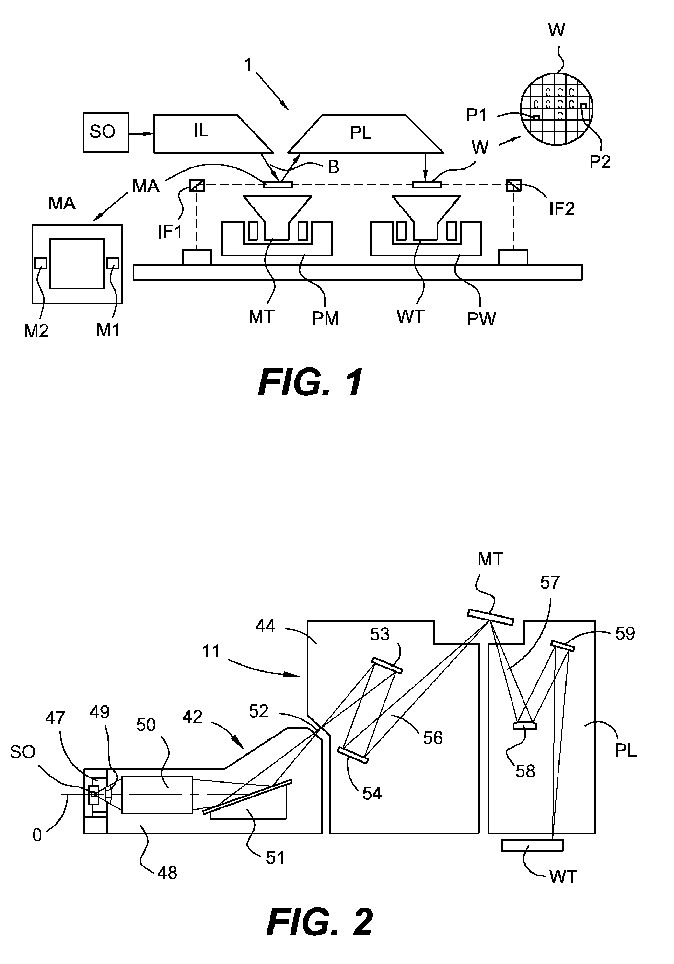

Figure 1 schematically depicts a lithographic apparatus 1 according to an embodiment of the present invention. The apparatus 1 includes an illumination system (illuminator) IL configured to condition a radiation beam B (e.g. UV radiation or EUV radiation). A patterning device support (e.g. a mask table) MT is configured to support a patterning device (e.g. a mask) MA and is connected to a first positioning device PM configured to accurately position the patterning device in accordance with certain parameters. A substrate table (e.g. a wafer table) WT is configured to hold a substrate (e.g. a resist-coated wafer) W and is connected to a second positioning device PW configured to accurately position the substrate in accordance with certain parameters. A projection system (e.g. a refractive projection lens system) PL is configured to project the patterned radiation beam B onto a target portion C (e.g. including one or more dies) of the substrate W.

The illumination system may include various types of optical components, such as refractive, reflective, magnetic, electromagnetic, electrostatic or other types of optical components, or any combination thereof, to direct, shape, or control radiation.

The patterning device support MT holds the patterning device in a manner that depends on the orientation of the patterning device, the design of the lithographic apparatus, and other conditions, such as for example whether or not the patterning device is held in a vacuum environment. The patterning device support can use mechanical, vacuum, electrostatic or other clamping techniques to hold the patterning device. The patterning device support may be a frame or a table, for example, which may be fixed or movable as required. The patterning device support may ensure that the patterning device is at a desired position, for example with respect to the projection system.

Any use of the terms "reticle" or "mask" herein may be considered synonymous with the more general term "patterning device."

The term "patterning device" as used herein should be broadly interpreted as referring to any device that can be used to impart a radiation beam with a pattern in its cross-section such as to create a pattern in a target portion of the substrate. It should be noted that the pattern imparted to the radiation beam may not exactly correspond to the desired pattern in the target portion of the substrate, for example if the pattern includes phase-shifting features or so called assist features. Generally, the pattern imparted to the radiation beam will correspond to a particular functional layer in a device being created in the target portion, such as an integrated circuit.

The patterning device may be transmissive or reflective. Examples of patterning devices include masks, programmable mirror arrays, and programmable LCD panels. Masks are well known in lithography, and include mask types such as binary, alternating phase-shift, and attenuated phase-shift, as well as various hybrid mask types. An example of a programmable mirror array employs a matrix arrangement of small mirrors, each of which can be individually tilted so as to reflect an incoming radiation beam in different directions. The tilted mirrors impart a pattern in a radiation beam which is reflected by the mirror matrix.

The term "projection system" as used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid or the use of a vacuum. Any use of the term "projection lens" herein may be considered as synonymous with the more general term "projection system".

As here depicted, the apparatus is of a reflective type, for example employing a reflective mask. Alternatively, the apparatus may be of a transmissive type, for example employing a transmissive mask.

The lithographic apparatus may be of a type having two (dual stage) or more substrate tables (and/or two or more mask tables). In such "multiple stage" machines the additional tables may be used in parallel, or preparatory steps may be carried out on one or more tables while one or more other tables are being used for exposure.

The lithographic apparatus may also be of a type wherein at least a portion of the substrate may be covered by a liquid having a relatively high refractive index, e.g. water, so as to fill a space between the projection system and the substrate. An immersion liquid may also be applied to other spaces in the lithographic apparatus, for example, between the mask and the projection system. Immersion techniques are well known in the art for increasing the numerical aperture of projection systems. The term "immersion" as used herein does not mean that a structure, such as a substrate, must be submerged in liquid, but rather that liquid is located, for example, between the projection system and the substrate during exposure.

Referring to Figure 1, the illuminator IL receives radiation from a radiation source SO. The source and the lithographic apparatus may be separate entities, for example when the source is an excimer laser. In such cases, the source is not considered to form part of the lithographic apparatus and the radiation is passed from the source SO to the illuminator IL with the aid of a delivery system (not shown in Figure 1) including, for example, suitable directing mirrors and/or a beam expander. In other cases the source may be an integral part of the lithographic apparatus, for example when the source is a mercury lamp. The source SO and the illuminator IL, together with the beam delivery system if required, may be referred to as a radiation system.

The illuminator IL may include an adjusting device (not shown in Figure 1) configured to adjust the angular intensity distribution of the radiation beam. Generally, at least the outer and/or inner radial extent (commonly referred to as σ-outer and σ-inner, respectively) of the intensity distribution in a pupil plane of the illuminator can be adjusted. In addition, the illuminator IL may include various other components, such as an integrator and a condenser (not shown in Figure 1). The illuminator may be used to condition the radiation beam, to have a desired uniformity and intensity distribution in its cross-section.

The radiation beam B is incident on the patterning device (e.g., mask) MA, which is held on the patterning device support (e.g., mask table) MT, and is patterned by the patterning device. After being reflected by the patterning device (e.g. mask) MA, the radiation beam B passes through the projection system PL, which focuses the beam onto a target portion C of the substrate W. With the aid of the second positioning device PW and a position sensor IF2 (e.g. an interferometric device, linear encoder or capacitive sensor), the substrate table WT can be moved accurately, e.g. so as to position different target portions C in the path of the radiation beam B. Similarly, the first positioning device PM and a position sensor IF1 (e.g. an interferometric device, linear encoder or capacitive sensor) can be used to accurately position the patterning device (e.g. mask) MA with respect to the path of the radiation beam B, e.g. after mechanical retrieval from a mask library, or during a scan. In general, movement of the patterning device support (e.g. mask table) MT may be realized with the aid of a long-stroke module (coarse positioning) and a short-stroke module (fine positioning), which form part of the first positioning device PM. Similarly, movement of the substrate table WT may be realized using a long-stroke module and a short-stroke module, which form part of the second positioning device PW. In the case of a stepper, as opposed to a scanner, the patterning device pattern support (e.g. mask table) MT may be connected to a short-stroke actuator only, or may be fixed. Patterning device (e.g. mask) MA and substrate W may be aligned using patterning device alignment marks M1, M2 and substrate alignment marks P1, P2. Although the substrate alignment marks as illustrated occupy dedicated target portions, they may be located in spaces between target portions. These are known as scribe-lane alignment marks. Similarly, in situations in which more than one die is provided on the patterning device (e.g. mask) MA, the patterning device alignment marks may be located between the dies.

The depicted apparatus could be used in at least one of the following modes:

1. In step mode, the patterning device support (e.g. mask table) MT and the substrate table WT are kept essentially stationary, while an entire pattern imparted to the radiation beam is projected onto a target portion C at one time (i.e. a single static exposure). The substrate table WT is then shifted in the X and/or Y direction so that a different target portion C can be exposed. In step mode, the maximum size of the exposure field limits the size of the target portion C imaged in a single static exposure.

2. In scan mode, the patterning device support (e.g. mask table) MT and the substrate table WT are scanned synchronously while a pattern imparted to the radiation beam is projected onto a target portion C (i.e. a single dynamic exposure). The velocity and direction of the substrate table WT relative to the patterning device support (e.g. mask table) MT may be determined by the (de-)magnification and image reversal characteristics of the projection system PL. In scan mode, the maximum size of the exposure field limits the width (in the non-scanning direction) of the target portion in a single dynamic exposure, whereas the length of the scanning motion determines the height (in the scanning direction) of the target portion.

3. In another mode, the patterning device support (e.g. mask table) MT is kept essentially stationary holding a programmable patterning device, and the substrate table WT is moved or scanned while a pattern imparted to the radiation beam is projected onto a target portion C. In this mode, generally a pulsed radiation source is employed and the programmable patterning device is updated as required after each movement of the substrate table WT or in between successive radiation pulses during a scan. This mode of operation can be readily applied to maskless lithography that utilizes programmable patterning device, such as a programmable mirror array of a type as referred to above.

Combinations and/or variations on the above described modes of use or entirely different modes of use may also be employed.

Figure 2 shows the projection apparatus 1 in more detail, including a radiation system 42, an illumination optics unit 44, and the projection system PL. The radiation system 42 includes the radiation source SO which may be formed by a discharge plasma. EUV radiation may be produced by a gas or vapor, such as Xe gas, Li vapor or Sn vapor in which a very hot plasma is created to emit radiation in the EUV range of the electromagnetic spectrum. The very hot plasma is created by causing a partially ionized plasma of an electrical discharge to collapse onto an optical axis O. This source may be referred to as a discharge produced plasma (LPP) source. Partial pressures of 10 Pa of Xe, Li, Sn vapor or any other suitable gas or vapor may be required for efficient generation of the radiation. The radiation emitted by radiation source SO is passed from a source chamber 47 into a collector chamber 48 via a gas barrier structure or contamination trap 49 which is positioned in or behind an opening in source chamber 47. The gas barrier structure/ contamination trap 49 includes a channel structure such as, for example, described in detail in United States patent nos. 6,614,505 and 6,359,969.

The collector chamber 48 includes a radiation collector 50 which may be formed by a grazing incidence collector. Radiation passed by collector 50 is reflected off a grating spectral filter 51 to be focused in a virtual source point 52 at an aperture in the collector chamber 48. From collector chamber 48, a radiation beam 56 is reflected in illumination optics unit 44 via normal incidence reflectors 53, 54 onto a patterning device (e.g. reticle or mask) positioned on patterning device support (e.g. reticle or mask table) MT. A patterned beam 57 is formed which is imaged in projection system PL via reflective elements 58, 59 onto wafer stage or substrate table WT. More elements than shown may generally be present in illumination optics unit 44 and projection system PL.

The radiation collector 50 may be a collector as described in European patent application no. 03077675.1, which is incorporated herein by reference.

Alternatively, in other embodiments, the radiation collector may be one or more of a collector configured to focus collected radiation into the radiation beam emission aperture; a collector having a first focal point that coincides with the source and a second focal point that coincides with the radiation beam emission aperture; a normal incidence collector; a collector having a single substantially ellipsoid radiation collecting surface section; and a Schwarzschild collector having two radiation collecting surfaces.

Also, in an embodiment, the radiation source SO may be a laser produced plasma (LPP) source including a light source that is configured to focus a beam of coherent light, of a predetermined wavelength, onto a fuel.

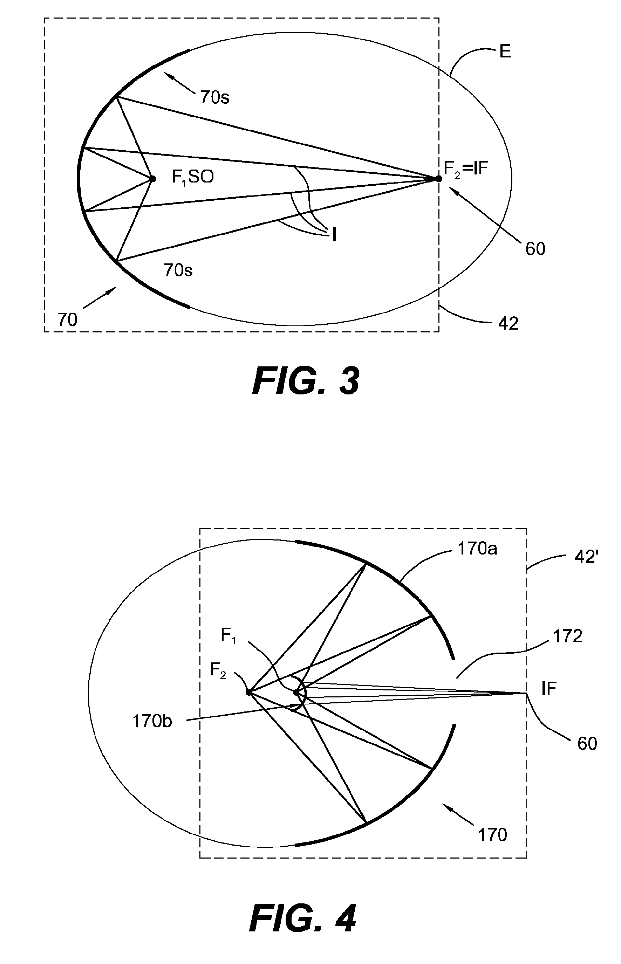

For example, Figure 3 shows an embodiment of a radiation system 42, in cross-section, including a normal incidence collector 70. The collector 70 has an elliptical configuration, having two natural ellipse focus points F1, F2. Particularly, the normal incidence collector includes a collector having a single radiation collecting surface 70s having the geometry of the section of an ellipsoid. In other words: the ellipsoid radiation collecting surface section extends along a virtual ellipsoid (part of which is depicted by as dotted line E in the drawing).

As will be appreciated by the skilled person, in case the collector mirror 70 is ellipsoidal (i.e., including a reflection surface 70s that extends along an ellipsoid), it focuses radiation from one focal point F1 into another focal point F2. The focal points are located on the long axis of the ellipsoid at a distance $f = (a^2-b^2)^{1/2}$ from the center of the ellipse, where 2a and 2b are the lengths of the major and minor axes, respectively. In case that the embodiment shown in Figure 1 includes an LPP radiation source SO, the collector may be a single ellipsoidal mirror as shown in Figure 3, where the light source SO is positioned in one focal point (F1) and an intermediate focus IF is established in the other focal point (F2) of the mirror. Radiation emanating from the radiation source, located in the first focal point (F1) towards the reflecting surface 70s and the reflected radiation, reflected by that surface towards the second focus point F2, is depicted by lines 1 in the drawing. For example, according to an embodiment, a mentioned intermediate focus IF may be located between the collector and an illumination system IL (see Figures 1, 2) of a lithographic apparatus, or be located in the illumination system IL, if desired.

Figure 4 schematically shows a radiation source unit 42' in accordance with an embodiment of the invention, in cross-section, including a collector 170. In this case, the collector includes two normal incidence collector parts 170a, 170b, each part 170a, 170b preferably (but not necessarily) having a substantially ellipsoid radiation collecting surface section. Particularly, the embodiment of Figure 4 includes a Schwarzschild collector design, preferably consisting of two mirrors 170a, 170b. The source SO may be located in a first focal point F1. For example, the first collector mirror part 170a may have a concave reflecting surface (for example of ellipsoid or parabolic shape) that is configured to focus radiation emanating from the first focal point F1 towards the second collector mirror part 170b, particularly towards a second focus point F2. The second mirror part 170b may be configured to focus the radiation that is directed by the first mirror part 170a towards the second focus point F2, towards a further focus point IF (for example an intermediate focus). The first mirror part 170a includes an aperture 172 via which the radiation (reflected by the second mirror 170b) may be transmitted towards the further focus point IF. For example, the embodiment of Figure 4 may beneficially be used in combination with a DPP radiation source.

The radiation collector 70 may be configured to collect radiation generated by the source, and to focus collected radiation to the downstream radiation beam emission aperture 60 of the radiation system 42.

For example, the source SO may be configured to emit diverging radiation, and the collector 70 may be arranged to reflect that diverging radiation to provide a converging radiation beam, converging towards the emission aperture 60 (as in Figures 3 and 4). Particularly, the collector 70 may focus the radiation onto a focal point IF on an optical axis O of the system (see Figure 2), which focal point IF is located in the emission aperture 60.

The emission aperture 60 may be a circular aperture, or have another shape (for example elliptical, square, or another shape). The emission aperture 60 is preferably small, for example having a diameter less than about 10 cm, preferably less than 1 cm, (measured in a direction transversally with a radiation transmission direction T, for example in a radial direction in case the aperture 60 has a circular cross-section). Preferably, the optical axis O extends centrally through the aperture 60, however, this is not essential.

When a tin (Sn) based EUV radiation source is used, it may also produce Sn that contaminates the EUV collector. In order to achieve a sufficient lifetime for the EUV lithography tool, it is desirable to remove Sn from the EUV collector mirror. This removal procedure of Sn may be referred to as a cleaning procedure.

Hydrogen radicals may be applied to remove Sn contamination from various samples. The cleaning rate of Sn generally varies depending on the substrate. Additional information regarding cleaning with hydrogen radicals can be gleaned from United States patent application publication no. 2006/0115771, the content of which is incorporated herein in its entirety by reference.

It is possible to obtain a cleaning rate greater than about 1 nm/sec for a silicon substrate. After cleaning, all Sn is removed from the silicon substrate. On silicon, a cleaning rate of >700 nm/hour was demonstrated and after cleaning, all Sn had been removed from the substrate. When using a very thick layer of Sn, the cleaning rate was much lower at -200 nm/hour. However, when using a very thick layer of Sn, the cleaning rate may be much lower. Experiments on Ru substrates have shown that the cleaning rate is even more reduced on Ru and full cleaning (i.e. all Sn removed from substrate) may not be possible for Ru.

One solution to improve the cleaning process of optics is to add a cleaning cap layer to a multi-layer mirror surface. Hydrogen radicals may be applied to remove Sn from multi-layer mirrors with varying capping layers. The application of a cleaning cap layer is not always possible, for example, because a collector mirror is exposed to ion etching, which results in etching of the cleaning cap layer.

In an embodiment, it is proposed to use a Mo/Si mirror in combination with hydrogen radical cleaning, where the Mo/Si mirror does not have a capping layer. This configuration provides unexpected results because it was previously believed that a high hydrogen recombination rate results in extremely slow Sn removal. However, when Mo is used, the cleaning rate turns out to still be high despite a high hydrogen recombination rate. Thus, the behavior of Mo is very different from the behavior of Ru. This is unexpected because both materials have a very high hydrogen recombination rate. In an embodiment, it is possible to fully clean a multi-layer with Mo-top or Si-top.

According to an embodiment of the invention, a Mo layer is sandwiched between two succeeding Si layers. By applying an intermediate Mo layer, good Sn cleaning properties may be obtained, since it unexpectedly appears that Sn can relatively easily be removed from both Si and Mo substrates.

According to an embodiment of the invention, the mirror includes a multi-layer structure including alternating Mo/Si layers, optionally provided with diffusion barrier layers, wherein a boundary Mo layer, a boundary Si layer or a boundary diffusion barrier layer of the alternating layers forms a top layer of the mirror, the top layer facing inwardly with respect to the chamber. As a result, a boundary Si layer, a boundary Mo layer or a boundary diffusion barrier layer faces towards the incoming radiation. According to an embodiment of the invention, the mirror is free of a capping layer.

In an embodiment, there is provided a source of hydrogen radicals, directed towards a multi-layer mirror. This embodiment is characterized by the fact that the multi-layer mirror does not include a capping layer. Preferably, the mirror comprises a Mo/Si multi-layer mirror, optionally provided with diffusion barriers, e.g. $B_4C$ diffusion barrier layers. The diffusion barrier layers are interposed between succeeding Mo layers and Si layers of the multilayer. Further, a diffusion barrier layer may be located as a top layer of the multilayer.

When the Mo/Si mirror is exposed to high temperatures, e.g a temperature larger than 70 °C, the Mo and Si layers may start to intermix, due to which EUV reflectivity will be strongly reduced. This may be solved using the above-mentioned intermediate diffusion barriers, which are thin layers of for example $B_4C$, placed between Mo and Si layers. The use of diffusion barriers may be especially relevant for EUV collector mirrors, because these mirrors are typically exposed to a relatively high heat-load compared to other mirrors in the EUV lithography system.

According to an embodiment of the invention, the top layer of the mirror is formed by a Si layer of the multilayer. According to an embodiment of the invention, the top layer of the mirror is formed by a Mo layer of the multilayer. According to an embodiment of the invention, the top layer of the mirror is a boundary diffusion barrier layer.

According to an embodiment of the invention, the multi-layer comprises several hundreds of alternating Mo layers and Si layers, e.g. approximately 400 layers, thereby increasing a lifetime of the mirror and/or postponing a replacing period of the mirror.

Embodiments of the invention may be particularly beneficial when the mirror forms a part of a multi-layer collector, such as in an EUV application. As a collector mirror is exposed to ion etching, it is undesirable to use a cleaning cap layer. The EUV source is desirably a laser produced plasma (LPP) source or a discharge produced plasma source (DPP) EUV source.

In an embodiment, the hydrogen radical source is an external source, such as, for example, a hydrogen gas supply in combination with a hot-filament or RF discharge. In an embodiment, the hydrogen radical source is integrated with the EUV source. For example, the EUV radiation may be directed through a gas mixture comprising Ar and $H_2$, which may result in the generation of H radicals. In another example, hydrogen radicals may be generated using the heat from the laser pump of an LPP EUV source (for example this may be a high-power CO2 or Nd:YAG laser system).

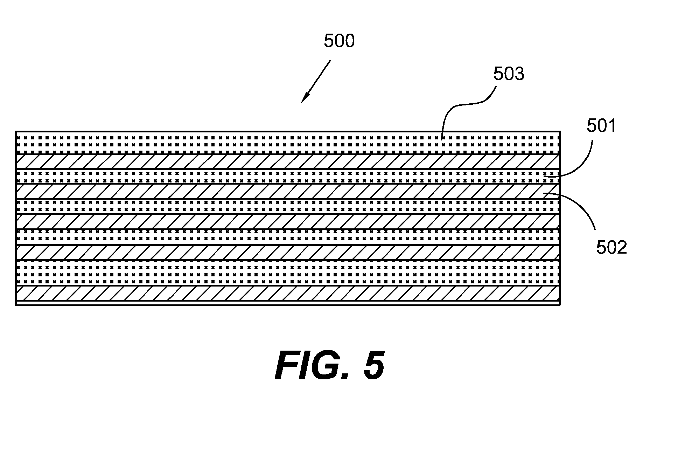

The following embodiments describe experiments to test Sn cleaning with hydrogen radicals on multi-layer mirrors. Samples used in this study were deposited at IPM, Moscow and are multi-layer Mo/Si mirrors with various capping layers. Figure 5 shows a multi-layer Mo/Si mirror 500 in accordance with an embodiment of the invention. The multilayer 500 comprises alternating Mo/Si layers 501, 502. In the illustrated embodiment, a boundary Mo layer 503 forms a top layer of the mirror 500. The top layer 503 faces inwardly with respect to the chamber.

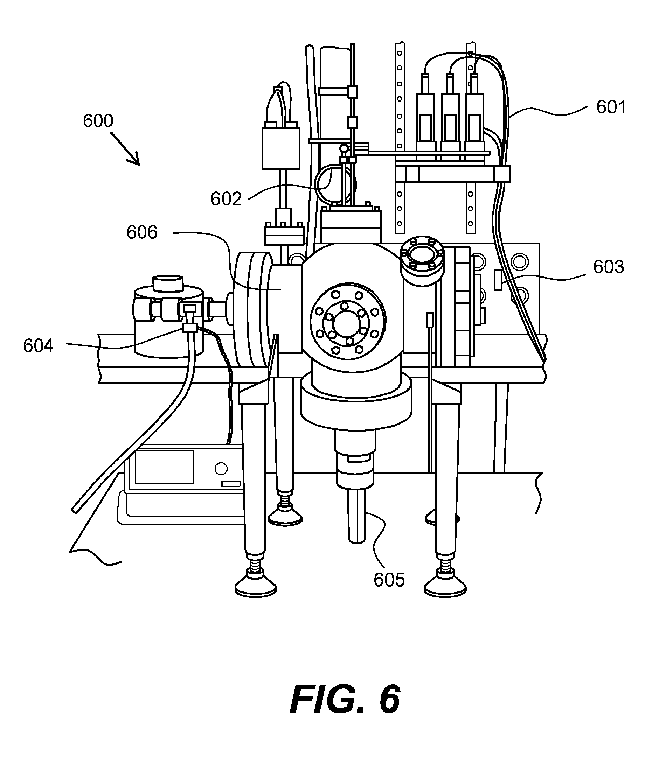

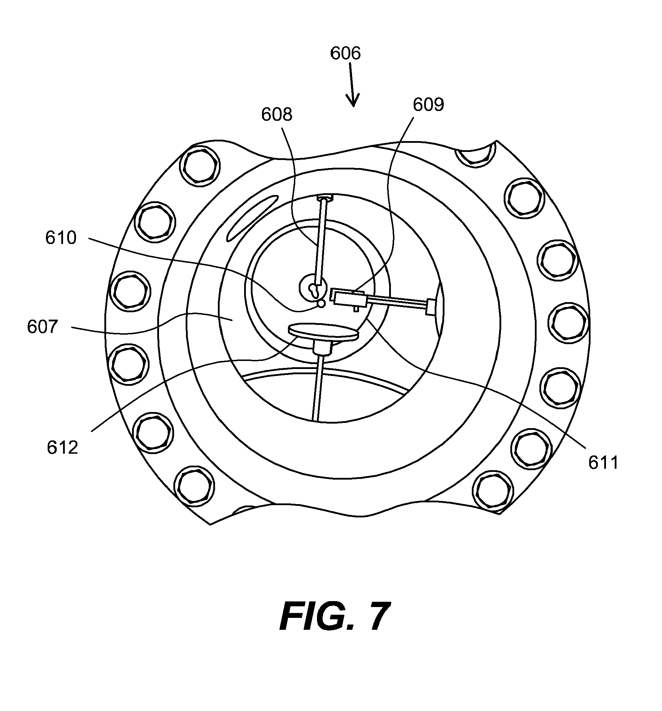

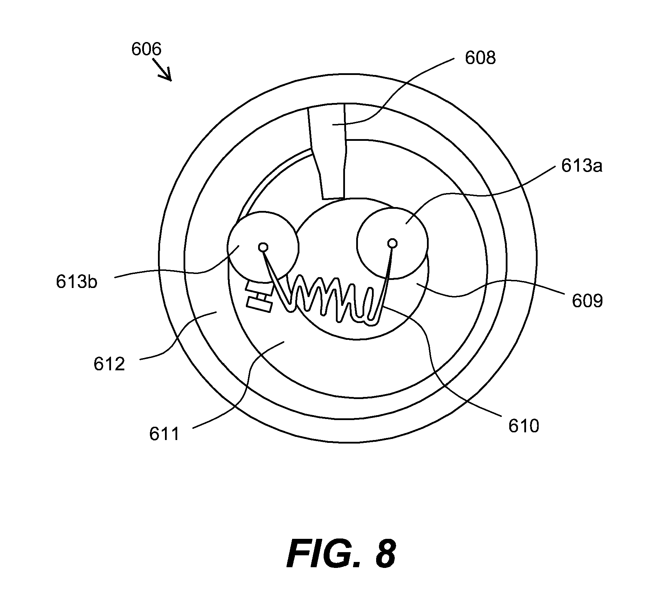

The experimental setup employs a hot filament within a vacuum chamber to dissociate hydrogen molecules ($H_2$) into hydrogen radicals. Figure 6 shows the front view of the experimental setup in accordance with an embodiment of the invention. The apparatus 600 includes a chamber 606, mass flow controllers 601, pressure meter 602, door 603, valve for controlling pressure 604 and a translation stage 605. The translation stage 605 is configured to move a substrate holder 612 (see Figures 7 and 8) along the vertical direction (as seen in Figure 6). The translation stage 605 may also be configured to move the stage in other degrees of freedom. A substrate is positioned on the substrate holder 612 within the chamber 606. The mass flow controllers are configured to control the supply of gas within the chamber 606. The pressure meter 602 is configured to control the pressure within the chamber 606.

Referring to Figures 7 and 8, these Figures show the interior of the chamber 606 in accordance with an embodiment of the invention. Figure 7 shows the side view of the chamber 606. Figure 8 shows the front view of the chamber 606. As shown in Figures 6 and 7, the chamber 606 includes a cavity 607 in which are arranged the substrate holder 612, a gas supply 608 and a thermocouple 611. Current is provided to a filament 610 with a current supply 609 including two poles 613a-b. The gas supply 608 is configured to supply hydrogen, which is dissociated into hydrogen radicals by heat generated by the filament 610. The substrate holder 612 is configured to hold a substrate including a multi-layer mirror.

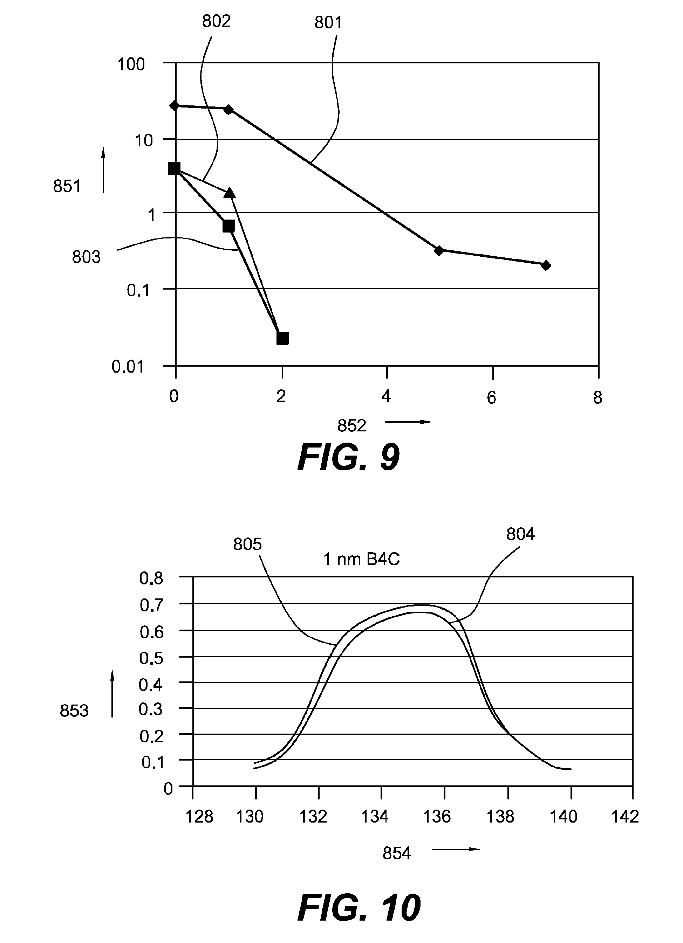

In an embodiment of the invention, a first series of experiments were conducted to compare the cleaning rate of three types of capping layers, which are Si (multi-layer with Si top), $Si_3N_4$ and $B_4C$. A layer of approximately 10 nm of Sn was deposited onto the multi-layer mirror and the amount of Sn was measured with x-ray fluorescence (XRF). The results are shown in Figure 9. Here, a remaining thickness 851 is depicted as a function of a number of treatments 852, each having a treatment duration of 10 seconds. The cleaning results are shown for a Si top layer 801, a $B_4C$ top layer 802 and a $Si_3N_4$ top layer 803. As can be seen in Figure 9, all capping layers can be cleaned sufficiently. The mirrors with $B_4C$ and $Si_3N_4$ top layers are fully cleaned within 2 treatments of 10 seconds, whereas the Si-top mirror has a lower cleaning rate, resulting in a remaining but acceptable Sn thickness of 0.2 nm Sn after 7x10 seconds of cleaning.

A second series of experiments was conducted in which samples were first measured with EUV reflectometry and measured again after deposition of approximately 10 nm of Sn. Next, the samples were cleaned for 4 x 10 seconds and EUV reflection was measured again. The samples used in this second series of experiments were $Si_3N_4$ (7 nm) and $B_4C$ (1, 1.5 and 2.5 nm).

Because EUV reflectivity measurements are not calibrated, the reflectivity was normalized by the reflectivity of the same sample before contamination. Table 1 shows a comparison between the EUV reflection at the beginning of the experiment and the EUV reflection after the cleaning procedure. It also shows the effect of Sn contamination on the reflectivity. As shown in Table 1, it can be seen that Sn contamination gives a reflectivity loss of 40%. However, in each scenario, the reflectivity could be fully recovered by hydrogen cleaning.

**Table 1: Recovery of 13.5 nm reflectivity after Sn cleaning of mirrors.**

| Sample | New reflectivity (%) | Change in reflectivity (%) |
|---|---|---|
| 404: 2.5 nm $B_4C$ cleaned | 100±0.2 | 0 |
| 439: 2.5 nm $B_4C$ + Sn | 61.42±0.2 | -38.58 |
| 513: 1.5 nm $B_4C$ cleaned | 100.2±0.16 | 0 |
| 524: 1.5 nm $B_4C$ + Sn | 51.3±0.1 | -48.7 |
| 622:1 nm $B_4C$ + Sn | 58.35±0.1 | -41.65 |
| 616: 1 nm $B_4C$ cleaned | 100±0.1 | 0 |
| 729: 7 nm Si3N4 + Sn | 48.27±0.1 | -51.7 |
| 705: 7 nm Si3N4 cleaned | 99.78±0.13 | -0.22±0.13 |

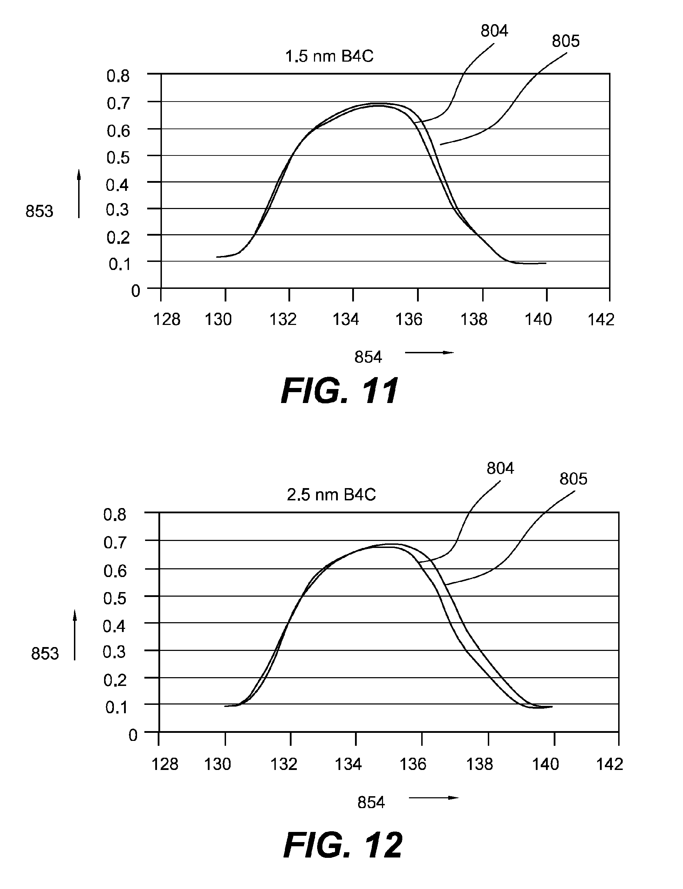

In order to see if the hydrogen radical treatment causes damage to the multi-layer mirrors, for example, due to heat (the maximum temperature was 40°C), reflectivity was also measured before and after the experiment for each sample. Results are shown in Figures 10, 11, 12 and 13, depicting a reflectivity 853 as a function of a wavelength 854. A reflectivity curve 804 before the experiment as well as a reflectivity curve 805 after the experiment are both shown. For these measurements, the exact value for the reflectivity may not be accurate, but from the curves it can be seen that there are no significant shifts in the reflection curve, indicating that the multi-layer stack is still intact.

For LPP EUV sources, most debris are due to ion etching. Desirably, the multi-layer stack is slowly etched away due to these ions, without the growth of Sn deposits. However, in practice, a non-uniform Sn deposition is often found, due to which certain areas of the collector are etched, whereas other areas have Sn deposition without etching, or combined with etching. Since the multi-layer mirror is slowly etched, and since it includes both Si and Mo layers, it is desirable to clean Sn from both layers. Therefore, during a cleaning operation, Sn is removed from multi-layer sections having a Si top layer and from multi-layer sections having a Mo top layer. In this context, it is noted that if Sn is deposited on multi-layer sections having a diffusion barrier top layer, the Sn is at least partially removed during the cleaning operation. It was previously shown that Sn can indeed be cleaned from a Si-top multi-layer mirror.

There might be a difference in the cleaning rates for Mo and Mo-oxide. In order to measure the effect of oxidation of the Mo layer, Mo samples on Si are used, instead of Mo-top multi-layer mirrors. Two types of samples were made. The first samples have a sputter deposited Mo layer (-100 nm), immediately followed by a sputter deposited Sn layer (-10 nm). The second type of samples first have a sputter deposited Mo layer (-100 nm), followed by an $O_2$ plasma treatment, after which the Sn layer is deposited (-10 nm).

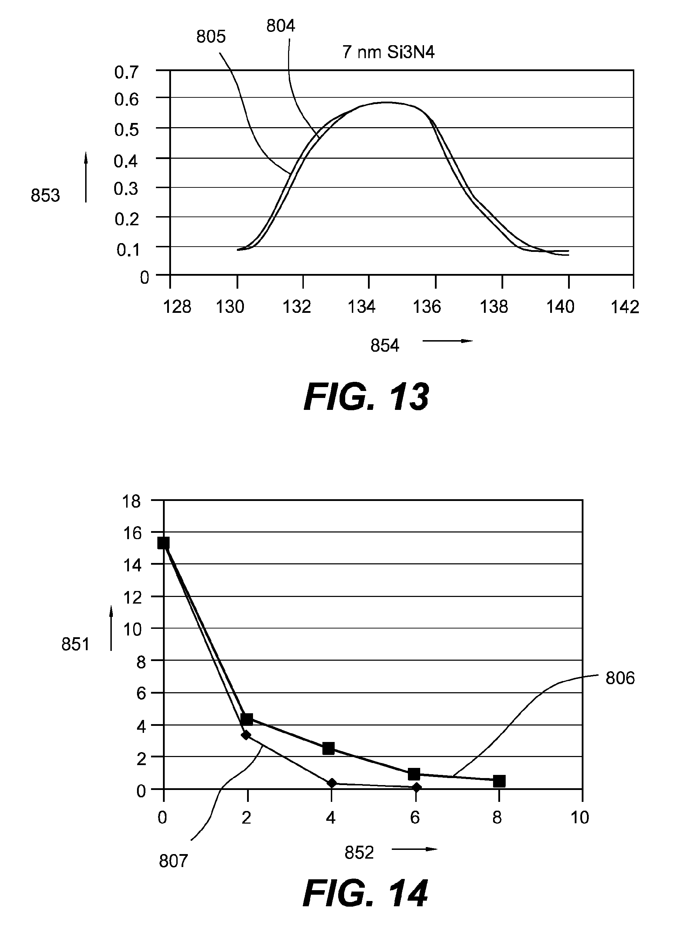

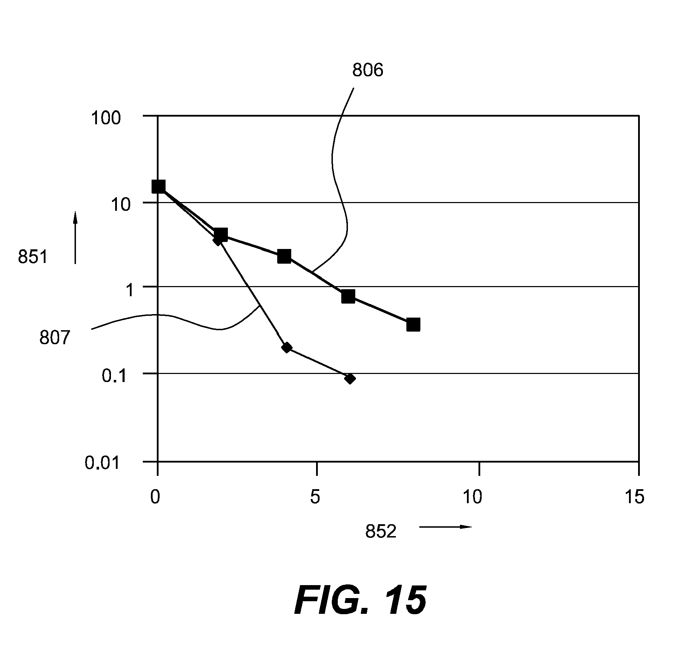

Results are shown in Figure 14 depicting a remaining thickness 851 as a function of a number of treatments 852, each having a treatment duration of 10 seconds. The cleaning results are shown for a Mo top layer 806 and for a Mo-oxide top layer 807. It can be seen that the cleaning rate of Mo-oxide is substantially higher than that of pure Mo. For Mo-oxide, most of the Sn has been removed after 6 treatments of 10 seconds, but for pure Mo, there is still 0.83 nm of Sn left at this point. However, it was also found that for pure Mo, Sn can still be removed, albeit at a slower cleaning rate. On a logarithmic plot, see Figure 15, this becomes clearer, and it can be extrapolated, that for pure Mo approximately 15 treatments are required in order to achieve an acceptable Sn thickness of 0.1 nm, compared to 6 treatments for Mo-oxide. It should also be noted that some of the achieved pure Mo cleaning may be due to the oxidation of Mo during the time between different treatments. This may have influenced these results, but since the cleaning curve is exponential while using the same time between measurements, this effect is probably small (since the time between experiments is similar, a similar oxidation is expected for every experiment).

Although specific reference may be made in this text to the use of lithographic apparatus in the manufacture of ICs, it should be understood that the lithographic apparatus described herein may have other applications, such as the manufacture of integrated optical systems, guidance and detection patterns for magnetic domain memories, flat-panel displays, liquid-crystal displays (LCDs), thin-film magnetic heads, etc. It should be appreciated that, in the context of such alternative applications, any use of the terms "wafer" or "die" herein may be considered as synonymous with the more general terms "substrate" or "target portion", respectively. The substrate referred to herein may be processed, before or after exposure, in for example a track (a tool that typically applies a layer of resist to a substrate and develops the exposed resist), a metrology tool and/or an inspection tool. Where applicable, the disclosure herein may be applied to such and other substrate processing tools. Further, the substrate may be processed more than once, for example in order to create a multi-layer IC, so that the term substrate used herein may also refer to a substrate that already contains multiple processed layers.

Although specific reference may have been made above to the use of embodiments of the invention in the context of optical lithography, it will be appreciated that the invention may be used in other applications, for example imprint lithography, and where the context allows, is not limited to optical lithography. In imprint lithography a topography in a patterning device defines the pattern created on a substrate. The topography of the patterning device may be pressed into a layer of resist supplied to the substrate whereupon the resist is cured by applying electromagnetic radiation, heat, pressure or a combination thereof. The patterning device is moved out of the resist leaving a pattern in it after the resist is cured.

While specific embodiments of the invention have been described above, it will be appreciated that the invention may be practiced otherwise than as described. For example, the invention may take the form of a computer program containing one or more sequences of machine-readable instructions describing a method as disclosed above, or a data storage medium (e.g. semiconductor memory, magnetic or optical disk) having such a computer program stored therein.

The descriptions above are intended to be illustrative, not limiting. Thus, it will be apparent to one skilled in the art that modifications may be made to the invention as described without departing from the scope of the claims set out below.

The invention is not limited to application of the lithographic apparatus or use in the lithographic apparatus as described in the embodiments. Further, the drawings usually only include the elements and features that are necessary to understand the invention. Beyond that, the drawings of the lithographic apparatus are schematically and not on scale. The invention is not limited to those elements, shown in the schematic drawings (e.g. the number of mirrors drawn in the schematic drawings). Further, the invention is not confined to the lithographic apparatus described in Figures 1 and 2. The person skilled in the art will understand that embodiments described above may be combined. Further, the invention is not limited to protection against, for example Sn from a source SO, but also other particles from other sources.

**Claims**

1. A lithographic apparatus comprising:

   a radiation source configured to produce extreme ultraviolet radiation, the radiation source including
   a chamber in which a plasma is generated;
   a mirror configured to reflect radiation emitted by the plasma, the mirror including a multi-layer structure including alternating Mo/Si layers, wherein a boundary Mo layer or a boundary Si layer or a boundary diffusion barrier layer of the alternating layers forms a top layer of the mirror, the top layer facing inwardly with respect to the chamber; and
   a hydrogen radical generator configured to generate hydrogen radicals in the chamber, the hydrogen radicals configured to remove debris generated by the plasma from the mirror.

2. The apparatus of claim 1, wherein the mirror forms a part of a multi-layer collector mirror.

3. The apparatus of claim 1, wherein the debris comprises tin particles.

4. The apparatus of claim 1, wherein the radiation source is a laser produced plasma source.

**5.** The apparatus of claim 1, wherein the radiation source is a discharge produced plasma source.

**6.** The apparatus of claim 1, wherein hydrogen having a pressure of about 100 Pa is supplied to the chamber.

**7.** The apparatus of claim 1, wherein the mirror is free of a capping layer.

**8.** The apparatus of claim 1, wherein the multi-layer structure including alternating Mo/Si layers, is provided with at least one diffusion barrier layer.

**9.** The apparatus of claim 8, wherein the diffusion barrier includes $B_4C$.

**10.** A radiation source configured to produce extreme ultraviolet radiation, the radiation source comprising:

a chamber in which a plasma is generated;
a mirror configured to reflect radiation emitted by the plasma, the mirror including a multi-layer structure including alternating Mo/Si layers, wherein a boundary Mo layer or a boundary Si layer or a boundary diffusion barrier layer of the alternating layers forms a top layer of the mirror, the top layer facing inwardly with respect to the chamber; and
a hydrogen radical generator configured to generate hydrogen radicals in the chamber, the hydrogen radicals configured to remove debris generated by the plasma from the mirror.

**11.** A device manufacturing method comprising:

generating a plasma that emits a beam of radiation;
reflecting the beam of radiation with a mirror, the mirror including a multi-layer structure including alternating Mo/Si layers, wherein a boundary Mo layer or a boundary Si layer or a boundary diffusion barrier layer of the alternating layers forms a top layer of the mirror, the top layer facing inwardly with respect to the chamber;
directing the beam of radiation onto a target portion of a substrate; and
removing debris produced by the plasma from a surface of the mirror with hydrogen radicals.

**12.** A mirror cleaning method, comprising:

removing debris using hydrogen radicals from a mirror that is arranged for reflecting a beam of extreme ultraviolet radiation emitted by a plasma in a chamber, the mirror including a multi-layer structure including alternating Mo/Si layers, wherein a boundary Mo layer or a boundary Si layer or a boundary diffusion barrier layer of the alternating layers forms a top layer of the mirror, the top layer facing inwardly with respect to the chamber.

**13.** A mirror cleaning method according to claim 12, further comprising removing debris from the top layer of the mirror.

**FIG. 1**

**FIG. 2**

**FIG. 3**

**FIG. 4**

500

503

501

502

**FIG. 5**

**FIG. 6**

**FIG. 7**

**FIG. 8**

**FIG. 9**

**FIG. 10**

**FIG. 11**

**FIG. 12**

**FIG. 13**

**FIG. 14**

FIG. 15

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6614505 B
- US 6359969 B
- EP 03077675 A
- WO 20060115771 A